(19) Europäisches Patentamt

European Patent Office

Office européen des brevets

(11) **EP 4 564 096 A1**

(12) **EUROPEAN PATENT APPLICATION**

(43) Date of publication:
04.06.2025 Bulletin 2025/23

(21) Application number: 23213585.5

(22) Date of filing: 01.12.2023

(51) International Patent Classification (IPC):
*G03F 7/20* (2006.01)

(52) Cooperative Patent Classification (CPC):
**G03F 7/70258; G03F 7/705**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventor: **STAALS, Frank
5500 AH Veldhoven (NL)**

(74) Representative: **ASML Netherlands B.V.
Corporate Intellectual Property
P.O. Box 324
5500 AH Veldhoven (NL)**

(54) **METHOD OF SETTING UP OF A LITHOGRAPHY APPARATUS**

(57) Disclosed is a method of determining compact lens model dependency data. The method comprises obtaining input lens model dependency data describing relationships between aberration data and a plurality of manipulators for manipulating elements of a projection system of a lithographic apparatus, said aberration data being described in terms of a first basis; determining correctable slit shapes relating to an exposure slit of the lithographic apparatus from the input lens model dependency data; determining at least one wavefront shape for each said correctable slit shape to determine a candidate matrix; determining a plurality of correctable components by ranking said candidate matrix in terms of correction potential and/or manipulator range usage, each said correctable component defining a basis function of a second basis, said second basis being different to said first basis; and determining compact lens model dependency data in terms of said second basis.

Fig. 4

**Description**

FIELD OF THE INVENTION

The present invention relates to methods and apparatus usable, for example, in the manufacture of devices by lithographic techniques, and to methods of manufacturing devices using lithographic techniques.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".
In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.
In device manufacturing methods using lithographic apparatus, an important factor is the yield, i.e., the percentage of correctly manufactured devices, is the accuracy within which layers are printed in relation to layers that have previously been formed. This is known as overlay and the overlay error budget will often be 10 nm or less. To achieve such accuracy, the substrate must be aligned to the reticle pattern to be transferred with great accuracy.
The process in which features with dimensions smaller than the classical resolution limit of a lithographic projection apparatus are printed, is commonly known as low-k, lithography, according to the resolution formula CD = k1 x $\lambda$/NA, where $\lambda$ is the wavelength of radiation employed (currently in most cases 248 nm or 193 nm), NA is the numerical aperture of projection optics in the lithographic projection apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection optics" as used herein should be broadly interpreted as encompassing various types of optical systems, including refractive optics, reflective optics, apertures and catadioptric optics, for example. The term "projection system" or "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.
To determine corrections for aberrations within the projection optics (e.g., aberrations for one or more lenses or projection optics), a lens model is typically used. The lithographic apparatus comprises a wavefront sensor able to measure wavefronts and therefore optical aberrations at the substrate plane. The lens model is used to translate these measured wavefronts into lens manipulator commands for correcting for the aberrations. The lens manipulators mechanically displace and/or thermally deform or otherwise act on each projection optic thereby changing its aberration profile, the combined effect of which is to reduce aberration at the substrate plane.
Because the projection optics of each lithographic apparatus will be different, each lens model should be individually calibrated. It would be desirable to improve methods of calibrating such a lens model.

## SUMMARY OF THE INVENTION

The invention in a first aspect provides a method of determining compact lens model dependency data comprising: obtaining input lens model dependency data describing relationships between aberration data and a plurality of manipulators for manipulating elements of a projection system of a lithographic apparatus, said aberration data being described in terms of a first basis; determining correctable slit shapes relating to an exposure slit of the lithographic apparatus from the input lens model dependency data; determining at least one wavefront shape for each said correctable slit shape to determine a candidate matrix; determining a plurality of correctable components by ranking said candidate matrix in terms of correction potential and/or manipulator range usage, each said correctable component defining a basis function of a second basis, said second basis being different to said first basis; and determining compact lens model dependency data in terms of said second basis.

The above and other aspects of the invention will be understood from a consideration of the examples described below.

## BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 is a flowchart describing a method for processing input lens dependency data to obtain compact lens dependency data forming part of a lens model;
Figure 4 is a representation of an ordered candidate matrix obtained when performing the method of Figure 3; and
Figure 5 is a flowchart describing a method for defining virtual manipulators and neutral virtual manipulators forming part of a lens model.

## DETAILED DESCRIPTION OF EMBODIMENTS

Before describing embodiments of the invention in detail, it is instructive to present an example environment in which embodiments of the present invention may be implemented.

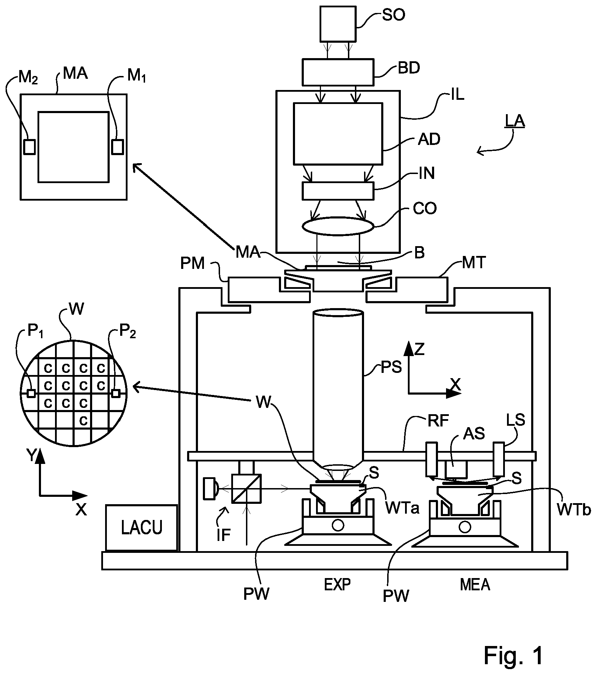

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device MA and substrate W and of features on them.

The illumination system IL may include various types of optical components, such as refractive, reflective, magnetic, electromagnetic, electrostatic or other types of optical components, or any combination thereof, for directing, shaping, or controlling radiation.

The patterning device support MT holds the patterning device MA in a manner that depends on the orientation of the patterning device MA, the design of the lithographic apparatus LA, and other conditions, such as for example whether or not the patterning device MA is held in a vacuum environment. The patterning device support MT can use mechanical, vacuum, electrostatic or other clamping techniques to hold the patterning device MA. The patterning device support MT may be a frame or a table, for example, which may be fixed or movable as required. The patterning device support MT may ensure that the patterning device MA is at a desired position, for example with respect to the projection system PS.

The term "patterning device" MA used herein should be broadly interpreted as referring to any device that can be used to impart a radiation beam with a pattern in its cross-section such as to create a pattern in a target portion C of the substrate W. It should be noted that the pattern imparted to the radiation beam may not exactly correspond to the desired pattern in the target portion C of the substrate W, for example if the pattern includes phase-shifting features or so called assist features. Generally, the pattern imparted to the radiation beam will correspond to a particular functional layer in a device being created in the target portion C, such as an integrated circuit.

As here depicted, the apparatus is of a transmissive type (e.g., employing a transmissive patterning device).

Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" PS used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus LA may also be of a type wherein at least a portion of the substrate W may be covered by a liquid having a relatively high refractive index, e.g., water, so as to fill a space between the projection system PS and the substrate W. An immersion liquid may also be applied to other spaces in the lithographic apparatus, for example, between the mask MA and the projection system PS. Immersion techniques are well known in the art for increasing the numerical aperture NA of projection systems.

In operation, the illuminator IL receives a radiation beam from a radiation source SO. The source and the lithographic apparatus LA may be separate entities, for example when the source is an excimer laser. In such cases, the source is not considered to form part of the lithographic apparatus LA and the radiation beam is passed from the source SO to the illuminator IL with the aid of a beam delivery system BD including, for example, suitable directing mirrors and/or a beam expander. In other cases the source may be an integral part of the lithographic apparatus LA, for example when the source is a high-pressure arc-lamp (e.g., a mercury lamp) of a solid state source. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator may be adjusted. In addition, the illuminator IL may comprise various other components, such as an integrator IN and a condenser CO. The illuminator IL may be used to condition the radiation beam B, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

The lithographic apparatus may comprise an aberration sensor for the verification of an aberration fingerprint of the projection system PS. In an embodiment such an aberration fingerprint, i.e., aberrations per field point of the projection system PS, may be determined using a such wavefront aberration sensor. A wavefront aberration sensor of a known type, for instance such as described in US2002/0001088 may be used. Such a wavefront aberration sensor may be based on the principle of shearing interferometry and comprises a source module and a sensor module. The source module may comprise a patterned layer of chromium that is placed in the object plane (i.e., where during production the pattern of the patterning means is) of the projection system PS and has additional optics provided above the chromium layer. The combination provides a wavefront of radiation to the entire pupil of the projection system PS. The sensor module may comprise a patterned layer of chromium that is placed in the image plane of the projection system (i.e., where during production the substrate W is) and a camera that is placed some distance behind said layer of chromium. The patterned layer of chromium on the sensor module diffracts radiation into several diffraction orders that interfere with each other giving rise to an interferogram. The interferogram is measured by the camera. The aberrations in the projection lens can be determined by software based upon the measured interferogram. The wavefront aberration sensor may be configured to transfer information with respect to the aberration fingerprint towards the control unit.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g.,

mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

The illustrated lithographic apparatus LA is of a so-called dual stage type, which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The lithographic apparatus control unit LACU which controls all the movements and measurements of various actuators and sensors to receive substrates W and reticles MA and to implement the patterning operations. Lithographic apparatus control unit LACU also includes signal processing and data processing capacity to implement desired calculations relevant to the operation of the apparatus, e.g., based on *inter alia* level sensor LS data, alignment sensor AS data and feedback metrology data (e.g., one or more of *inter alia* overlay, focus, dose, critical dimension data). In practice, control unit LACU may be realized as a system of many sub-units, each handling the real-time data acquisition, processing and control of a subsystem or component within the apparatus.

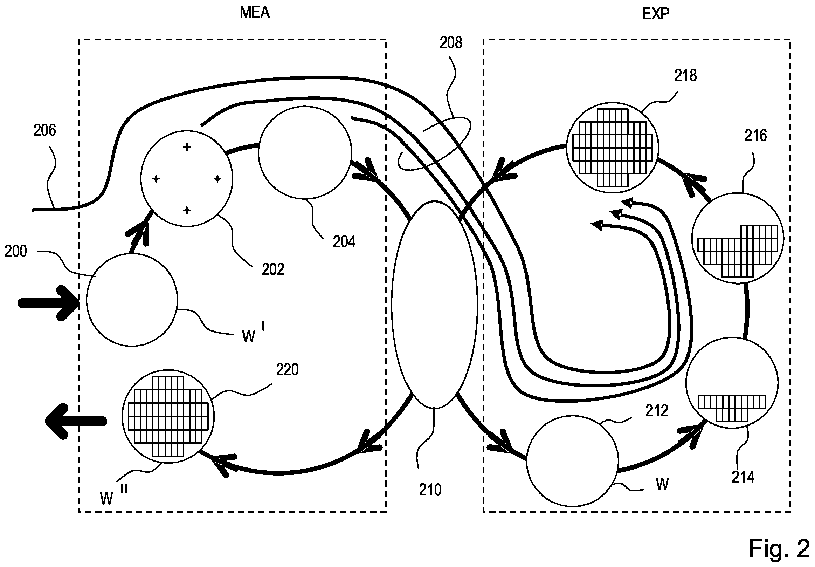

Figure 2 illustrates the steps to expose target portions (e.g., dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the alignment model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In a lithographic apparatus, it is known to control machine settings, e.g., lens settings and (reticle and substrate) stage settings, during exposures onto a substrate to optimize the projected image in terms of one or more placement parameters of interest, e.g., parameters related to placement of structures on the substrate. Such placement parameters of interest may comprise parameters on which device functionality and yield are dependent. In particular, the machine settings typically controlled include *inter alia* stage settings, lens control settings (e.g., to correct for lens aberration) and dose control settings. Stage settings may describe a planned or set stage movement such as described by various stage setpoints determined by the control hardware and software (e.g., as controlled by lithographic apparatus control unit LACU). These may relate to stage positioning, speed, and/or acceleration in each of the substrate plane (e.g., for placement/overlay control) and perpendicular to the substrate plane (e.g., for focus control).

In this manner, parameters of interest such as one or more of overlay, focus, and imaging (e.g., critical dimension (CD)) may be optimized. Such an optimization may comprise some trade-off between some of these parameters, but which ensure that each of these parameters of interest remain within-specification (e.g., within a tolerance indicative of a yielding or functional device). As such, "optimize" in the concept of this disclosure may simply mean improve and/or ensure that the parameter is within-specification. Of particular relevance to this disclosure are placement parameters of interest relating to structure placement, e.g., overlay.

Referring back to Figure 1, a sensor S is provided on the substrate table WT of the lithographic apparatus. The sensor S is configured to measure aberrations in the radiation beam projected by the projection system PS (which may also be referred to as the projection lens). The sensor S may for example comprise an imaging array (e.g., a CCD array) located a few millimetres below a diffraction grating (e.g., comprising several hundred lines). An object marker (not shown) which may for example consist of a few lines printed within a pinhole is provided either on the mask MA or on the mask table MT. In order to perform a measurement of the aberrations caused by the projection system PS, the mask table MT is moved such that the radiation beam B illuminates the object marker. The projection system PS forms an image of the object marker at the substrate table WTa (or WTb). The sensor S is positioned beneath the projection system PS to capture the far field image of the object marker. A series of object marker images are captured at different positions relative to the XY plane (i.e., different xy- direction positions using the Cartesian coordinates shown in Figure 1). The images are analyzed by a processor to provide measurements of the aberrations which have been introduced into the radiation beam B by the projection system PS. The aberrations may for example be expressed as a set of Zernikes. In an embodiment, Zernike coefficients Z2 to Z25 of the field orders offset, tilt, curvature and third order may be used to express the aberrations. Thus, a description of the state of the projection lens may have, for example, 96 coefficients (24 x 4). In alternative embodiments other ranges of Zernike coefficients may be used. For example Zernike coefficients up to Z64 may be used, or Zernike coefficients up to Z100 may be used.

A set of measurements may be performed with the object marker and sensor S at different x-direction positions along an area which is illuminated by the radiation beam B (the illuminated area may be referred to as an "exposure slit" or simply "slit"). Alternatively, the sensor S may comprise an imaging array (e.g., CCD array) which is sufficiently large to capture an image along the entire x-direction extent of the exposure slit. Where this is the case a set of object markers may be provided at mask level, the object markers being spaced apart along the x- direction of the exposure slit. Aberration measurements are then determined for each object marker of the set. In an embodiment the set of object markers may comprise seven object markers, and thus aberration measurements may be provided at seven positions spaced apart along the x-direction of the exposure slit. In some instances images may be captured away from a central line which bisects the exposure slit (which may correspond with y=0) and are used to provide aberration measurements.

The sensor S may be provided on a different support, for example a metrology module or support, wherein the different support is not arranged to support a substrate to be exposed.

The lithographic apparatus control unit LACU may be configured to adjust lenses of the projection system PS in order to correct the aberrations caused by the projection system PS. Several of the lenses of the projection system PS may be provided with manipulators, which are configured to modify the shape, position and/or orientation of those lenses. The effect of modifying the lens shapes, positions and orientations using the manipulators is well-known and thus the lens manipulators can be used to correct the aberration introduced by the projection system PS.

The lens manipulators may for example be mechanical actuators which apply compressive or stretching forces to edges of a lens, or may for example be heaters (for example wire-based heaters, fluid-based heaters, or optical (laser radiation) heaters), which are configured to selectively heat parts of a lens. The sensor S, lithographic apparatus control unit LACU and lens manipulators thus comprise a feedback loop which is used to measure aberrations and to correct measured aberrations. In one example, the sensor S and lithographic apparatus control unit LACU determine that a Z9 offset is present. This may be reduced by introducing a linear combination of manipulator adjustments which introduce the opposite Z9 offset. The linear combination of manipulator adjustments is determined by optimizing a merit function (typically a sum of squares of the measured aberrations) by treating the various lens manipulators as the degrees of freedom. If a is a vector containing all manipulator positions and z is a vector containing all the aberrations measured at the different positions in the exposure slit, then the aberrations resulting after a lens adjustment $\mathbf{z'}$ will be $\mathbf{z' = z - L \cdot a}$ where $\mathbf{L}$ is a matrix containing the 'lens dependencies' (the lens dependencies being a description of the aberrations introduced by each manipulator as described by a lens model). A simple example of a solution is the least- squares solution, where z' is minimized treating the vector a as the variable parameter set, giving $\mathbf{a_{min} = (L \cdot L^T)^{-1} \cdot L^T \cdot z}$. Solutions other than a least-squares solution may be used.

The feedback loop may thus be used to correct aberrations introduced by the projection system PS. It may not be possible to entirely remove all aberrations introduced by the projection system PS. However, reduction of the aberrations such that they fall below thresholds may be sufficient to allow projection of a pattern onto substrates with a desired accuracy using the projection system PS. References to correction of aberrations is not intended to mean that aberrations are entirely eliminated (this would be impractical). Instead, aberration correction may be interpreted as meaning a projection lens adjustment which reduces (or is intended to reduce) aberrations caused by the projection lens.

The lens dependencies may be determined on the assumption that aberration varies linearly with manipulation; however, this is not always strictly the case. In fact, linear lens dependencies may be, for example, 1-2% inaccurate, because they are set to a default for each scanner, and because they may be non-linear over their range.

Therefore, to calibrate the lens dependencies, each manipulator degree of freedom of each lens element may be stepped through its move range, while doing aberration measurements per slit position. It is not feasible to calibrate all manipulator dependencies singularly.

Presently, lens dependencies may relate a plurality of wavefronts (and/or aerial images) measured at different locations within the exposure slit to the set of manipulators and their induced aberrations on the lens elements within a pupil plane of the projection system. By way of example, the number of slit locations may be more than 20, more than 30, more than 40 or more than 50 (e.g., grid arrangements such as a 3 x 7 grid, 5 x 7 grid, 7 x 7 grid, 3 x 13 grid, 5 x 13 grid or 7 x 13 grid have been used. Other possible forms of a grid arrangements are rhomboidal grids or spoke-shaped grids which follow a curved field profile. The field points of each of these grid forms can be arranged in a matrix. For each of these slit locations, the lens dependencies may comprise an aberration description per manipulator. Assuming, for example, approximately 40 manipulators, a 5 x 13 slit location grid and an aberration description up to Z100, this means that the lens optimization may be performed on a data set on the order of (5 x 13) x (~40 x 100); although the 100 Zernike description does not contribute to the calibration time, as one wavefront measurement yields the 100 Zernikes. Because of this, only a selection of most important manipulator dependencies are typically calibrated.

Empirically optimizing dependencies on such a large data set is unwieldy, slow and possibly suboptimal. As such, a data-driven method for determining a more compact set of lens dependencies on an improved basis is proposed, e.g., beginning from a set of design / average scanner / approximate lens dependencies (input lens dependencies).

Such a method may optionally reduce the larger set of physical manipulators to a smaller set of virtual manipulators and neutral virtual manipulators. In this way, the solver matrix size may be reduced, and solution stabilized. Each virtual manipulator and neutral virtual manipulator may comprise a linear combination of physical manipulators, with the virtual manipulators inducing aberration and the neutral virtual manipulators having substantially negligible (or very little) effect on aberration. If one of the physical actuators forming part of a virtual manipulator clips, then the virtual manipulator becomes ineffective. The neutral virtual manipulators have a very small Zernike impact, but use actuator range and therefore can be used to re-center a clipping manipulator (or at least move it within range).

An important aspect in defining virtual manipulators is determining which linear combination of lens manipulators is most important in creating lens correction potential. A particular problem to be overcome is that all lens manipulators have very dominant lower order (e.g., Zernike Z2-Z6) content. The dominance of the lower order content (e.g., by a factor of between 100 to $10^4$ means that performing a multivariate analysis (e.g., principal component analysis PCA) directly on the lens dependencies is ineffective.

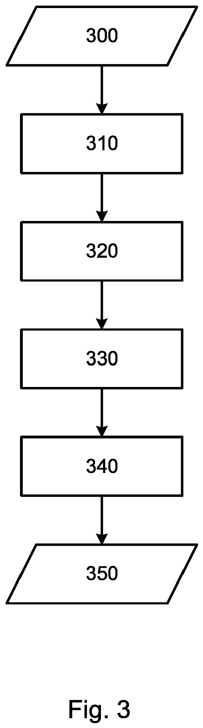

Figure 3 is a flowchart describing a method for processing input lens dependency data to obtain a new aberration basis on which compact lens dependency data (a compact lens dependency matrix) can be defined. In this way, the aberrations or pupil shapes may be defined according to a new basis set (set of basis functions) described by the new aberration basis (second basis), rather than Zernike basis (first basis).

The new aberration basis set and/or first compact lens dependency data can be used to determine second compact lens dependency data, such that the lens dependencies are described in terms of virtual manipulators; i.e., to describe the dependency of the aberrations (e.g., as described in terms of the new basis) on the virtual manipulators. The virtual manipulators may include neutral virtual manipulators, which can be used to shift the actual manipulators represented by the virtual manipulators within their ranges. Such a compact lens dependency matrix can then be used for lens modeling and/or for choosing the most important components to calibrate, e.g., as part of a lithographic process.

At step 310, the correctable slit shapes may be determined from input lens dependency data 300. The input lens dependency data 300 comprises a lens dependency matrix per slit location or slit sample point, and therefore may form a 3D matrix j x k x m, where j is the number of slit sample points (e.g., 65 or 5 x 13 in the specific example above). Each of these lens dependency matrices may be defined by the (integer) number of manipulators k in a first dimension and the aberration description (e.g., in terms of m aberration basis functions or Zernike functions - m being an integer) in a second dimension. Optionally, the Zernike description may be first evaluated to wavefronts, such that the resultant wavefronts (e.g., pixels of an image) are used for determining the correctable slit shapes. This yields the correct occurrence weights: Zernikes add up and cancel at wavefront positions. The pixel density may be determined so as to just cover the information of m Zernikes.

The correctable slit shapes may be determined by performing a first multivariate analysis (e.g., a principal component analysis (PCA)) over the lens dependency matrix dimension to find the main correctable slit shapes. The number of main correctable slit shapes may be fewer than 50, fewer than 40, fewer than 35, fewer than 30, fewer than 25, fewer than 20, fewer than 15, fewer than 12, fewer than 10, fewer than 9 or fewer than 8. The number of main correctable slit shapes may be more than 2, more than 3, more than 4, more than 5, more than 6, more than 8, more than 10, more than 15, more than 20 or more than 25. The number of main correctable slit shapes (principal components) may be pre-chosen, or may be chosen such that they explain at least a threshold percentage of the slit shape.

The result of step 310 is an integer number n of correctable slit shapes (e.g., in the region of 7 in one embodiment, although the number may be larger e.g., 20-30 when lens correction potential is high, which depends on the capability of the lens manipulator used) instead of many tens (e.g., 5 x 13) slit sample points. Each of the n correctable slit shapes has an associated lens dependency matrix (e.g., of dimension k x m).

At step 320, one or more (e.g., a plurality of) pupil shapes or wavefront shapes may be determined for each of the n correctable slit shapes. This may comprise performing a second multivariate analysis or PCA over the k (manipulator) dimension to determine the main pupil shape(s) or wavefront shape(s) (e.g., described in terms of multiple Zernikes or otherwise). This step may comprise determining up to a maximum of k wavefront shapes, e.g., each being described by m Zernikes, for each combination of manipulator and correctable slit shape, resulting in a n x k' candidate matrix of slit shape and wavefront, where k'≤k, and where each matrix element is described by e.g., m Zernikes (i.e., an n x k' x m matrix).

At step 330, the candidates described by the candidate matrix may be ranked by a correction potential. This step may rank the candidates by one or more performance indicators (e.g., key performance indicators or KPIs). This may comprise ranking each of the pupil shapes or principal components (each initially corresponding to a respective manipulator) in accordance with the one or more KPIs. The KPIs may comprise one or more correctability KPIs and/or one or more manipulator range usage KPIs. This ranking step may also result in a reduction of the principal components to only those which are identified as being (sufficiently) correctable (i.e., correctable components). This may comprise discarding those components which do not meet a threshold for one or more of the KPIs, e.g., because they have negligible or low correction potential. The number of correctable components may be reduced to somewhere between, purely for example, 0.5 x k to 0.75 x k. This ranked candidate matrix defines a new aberration basis, such that any aberration can now be described in terms of the correctable components (e.g., purely as an example, the 0.5 x k to 0.75 x k correctable components) rather than, for example, Zernike basis (e.g., 5 x 13 x k x 100). As such, each correctable component comprises a representation or "picture", which was described previously in terms of a 5x13x100 dataset.

At step 340, the lens dependencies and input aberration may be rewritten in this new basis (e.g., the 'set' basis) of correctable components determined in step 330. It can be appreciated that any aberration not covered by this basis is non-correctable. As such, each correctable component describes a new basis function of a new basis, replacing the Zernike basis. The result is first compact lens dependency data 350, which is described in accordance with a new basis and comprises a considerably smaller dataset than the input lens dependency data 300, i.e., comprising a k x k" matrix, where k"<k. This rewriting in a new basis may comprise fitting the set of correctable components to the (original) input lens dependency data.

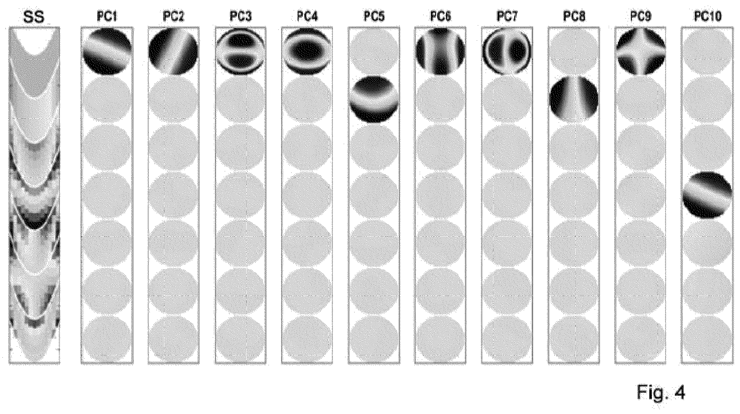

Figure 4 illustrates (a part of) the ranked candidate matrix resulting from step 330. Shown in this example, are seven slit shapes SS and (the first) ten correctable principal components PC1-PC10 (typically there may be more correctable principal components), with the principal components being ranked in terms of the KPI(s). Note that the numbering of the correctable components describes the ranking according to KPI(s). Each of these components PC1-PC10 is a linear combination of wavefronts or pupil shapes per the (e.g., 7) slit shapes. It can be seen that the majority of wavefronts per component is close to zero, this illustrating the physics behind the lens correction potential.

The KPIs may comprise, for example, one or more of: a set-get error KPI (e.g., describing a difference or error between a set or desired candidate wavefront slit shape (e.g., one of the representations or "pictures" of a single row of the candidate matrix) and the resultant obtained wavefront in the same slit shape (e.g., another shape or magnitude of the representation in the same row), a parasitic KPI (e.g., comprising a measure of unrequested or undesired wavefront slit shapes (e.g., representations in one or more of the other rows of the candidate matrix) for each set candidate wavefront slit shape, and a manipulator range usage KPI describing the magnitude of manipulator range used to obtain each candidate wavefront slit shape.

It can be appreciated that the candidate matrix is the setpoint. Using the lens dependencies and a solver model (e.g., with regularization as will be described) the 'get' profiles may be calculated. The 'get' profiles have the same or less amplitude for the 'set' candidate wavefront slit shape plus (typically) one or more parasitic wavefronts at other slit shapes. The get wavefronts for the requested slit shape is used to determine the set-get error KPI, and the get wavefronts for the other slit shapes is used to determine the parasitic KPI.

Step 330 may be repeated iteratively so as to optimize a respective regularization parameter or "rubberband" for each manipulator. As such, in determining the correctable components (candidates), constraints may be applied to limit manipulator range usage. An iterative algorithm will therefore be described which aims to prevent using very large balanced manipulator movements for only marginal correction gains. The algorithm may optimize a minimum required (e.g., nm) correction range per each correctable component.

The algorithm may comprise, prior to step 330, optimizing the constraints for the principal component "get" calculation (e.g., as performed to determine the set-get error KPI and/or parasitic KPI). Because these constraints are required for step 330, the result of which is required for the constraint optimization, this algorithm is performed iteratively till a target is met, e.g., a threshold correction potential is met for each correctable component. The threshold correction potential may be dependent on apparatus type as it typically scales with wavelength used and/or lens quality. For example, for EUV lithographic apparatuses, the threshold correction potential may be a value greater than 0.4 nm, greater than 0.5 nm, greater than 0.6 nm, greater than 0.7 nm, greater than 0.8 nm, greater than 0.9 nm, or greater than 1 nm for example. For lithographic apparatuses using larger (e.g., visible) wavelengths, these values may be larger (e.g., greater than 1 nm, greater than 2 nm, greater than 3 nm, greater than 4 nm or greater than 5 nm).

The regularization parameter (rubberbands) may comprise an addition to the optimization cost of:

$\sum_i \alpha_i * \Delta man_i^2$ where $\alpha_i$ is the regularization parameter value and $\Delta man_i$ is the setpoint change per manipulator i. Therefore, considering a simple example in terms of Zernikes Z2/Z3, an unregularized cost function may take the form:

$$Cost = a_{Z2} * Z2_{res}^2 + a_{Z3} * Z3_{res}^2$$

where $Z2_{res}$ is the Z2 residual and $a_{Z2}$ its coefficient, and $Z3_{res}$ is the Z3 residual and $a_{Z3}$ its coefficient. The Z2 residual may be (in a simplified 2 manipulator example):

$$Z2_{res} = Z2_{get} - Z2_{set} - \Delta man_1 * dep_{1Z2} - \Delta man_2 * dep_{2Z2}$$

where $Z2_{get}$ is the measured Z2 wavefront, $Z2_{set}$ the target or set Z2 wavefront, and $dep_{iZ2}$ is the Z2 dependencies for each manipulator. $Z3_{res}$ may be defined equivalently.

With the proposed regularization parameters, the cost function may become for this example:

$$Cost = a_{Z2} * Z2_{res}^2 + a_{Z3} * Z3_{res}^2 + \alpha_1 * \Delta man_1^2 + \alpha_2 * \Delta man_2^2$$

Manipulator movements improve the residuals, so reduce the cost. But at the same time they impose a small increase on the cost through the rubberbands. It means that that no (further) corrections are performed if the (additional) gain in Z2, Z3 is small.

As such, the method may comprise considering relative range usage per actuator. Initial values for the regularization parameter may be assumed (e.g., set all at 1 initially). If, over the candidate correctable components, an actuator is used at a maximum relative range of 200%, then its regularization parameter may be increased by a factor 2, such that in next iteration it will use less range. Similarly, if, over the candidate correctable components, an actuator is used at a maximum relative range of 50%, then its regularization parameter may be decreased by a factor 2, such that in next iteration it is allowed more range. As a result, over the candidates, actuator range usage is minimized while still reaching the required magnitude per candidate. The minimum required magnitude will be for more difficult candidates only, because if they have enough magnitude, then easier candidates can go to a higher magnitude with the same regularization parameters.

Following the determination of the lens dependencies in terms of the new basis, virtual manipulators may be defined in terms of the new basis (e.g., the 'get' basis). The virtual manipulators may comprise in their number, neutral virtual manipulators (e.g., more specifically, neutral virtual manipulators can be determined from the virtual manipulators), the action of which provide a small or negligible effect on aberration.

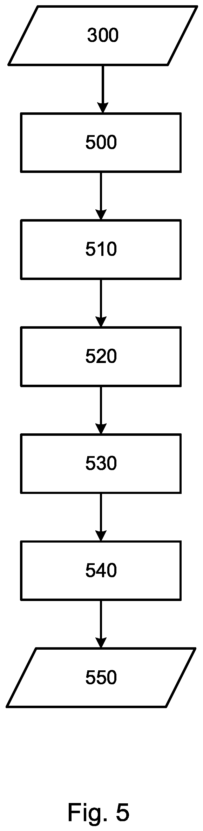

Figure 5 is a flowchart describing a method for defining the virtual manipulators. At step 500, the set correctable components are fitted to the input compact lens dependency data 300. In this fitting, the range usage constraints are not applied such that the fitting is based on ultimate correction potential.

At step 510, a third multivariate analysis or third PCA is performed on the fitted set correctable components from step 500 to identify dominant lens calibration dependency components. As such, this third PCA may be performed over the manipulators used by the most dominant components. The lens calibration dependency components may be normalized to the maximum manipulator range.

At step 520, the get correctable components (i.e., those obtained in a get-set analysis) are fitted to the input lens dependency data 300. The 'get' basis describes what the lens is able to do, and therefore this fitting is done with the regularization parameters or rubberbands applied. A method for performing a get-set analysis has already been described.

At step 530, virtual manipulators are defined. This may comprise combining (e.g., multiplying) the fitted get correctable components from step 500 with the lens calibration dependency components determined at step 520. This changes the lens dependency data from being described in terms of the actual physical manipulators to being described in terms of virtual manipulators; e.g., linear combinations of the few (dominant) manipulators, which can be used for correction of each correctable component.

At step 540, neutral virtual manipulators are defined. This may comprise fitting each of the virtual manipulators determined at step 530 on all of the other virtual manipulators to obtain linear combinations of virtual manipulator settings, and finding amongst these linear combinations of virtual manipulator settings, those which approximate zero aberration impact. The resultant linear combinations may be normalized to maximum manipulator range. As such, the neutral virtual manipulators can be defined by performing a fourth multivariate analysis or fourth PCA on the linear combinations to find the main linear combinations of virtual manipulators approximating zero aberration impact (neutral candidates). The neutral candidates may be evaluated in terms of the 'get' components to select those with smallest aberration impact.

The result is a lens dependency matrix 550 or second compact lens dependency data which describes the dependencies of the correctable components in terms of the virtual manipulators (and neutral virtual manipulators, although the dependency will be negligible with the neutral virtual manipulators). These virtual manipulators (including the neutral virtual manipulators) and the second compact lens dependency data can then be used in lens modeling. Furthermore, the one or more virtual manipulators can be calibrated for improved lens modeling accuracy. For example, all the virtual manipulators or a chosen few (for example, the most dominant virtual manipulators, that may be determined according to the third PCA or otherwise).

The lens dependency matrix 550 obtained by this method may comprise a q x r matrix, where one or both of the number of correctable components q and the number of virtual manipulators (including neutral) r are respectively fewer than 300, fewer than 250, fewer than 100, fewer than 40, fewer than 36, fewer than 34, fewer than 32 or fewer than 30. The actual number has a large dependence on the number of physical manipulators, and therefore the lithographic apparatus type. As such, the lens dependency data may be compressed (using purely exemplary but realistic values) from something on the order of (5 x 13) x (40 x 100), to something on the order of 28 x 28.

It can be appreciated that the order of some of the steps of the methods above may be varied or changed where appropriate, for example, where it is clear that the order is not critical or important.

Such a method replaces the need to tune regularization of each individual manipulator to optimize the lens model.

The present method is, by contrast, data-determined with little tuning required; the only tuning being that of selecting a threshold or minimum actuation range per aberration component and the manipulator min/max ranges. The other lens dependency optimization steps are automated.

The proposed methods may, for example, be performed using the lithographic apparatus control unit LACU shown and described in relation to Figure 1.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Aspects of the invention are set out in the clauses below.

1. A method of determining compact lens model dependency data; the method comprising:

obtaining input lens model dependency data describing relationships between aberration data and a plurality of manipulators for manipulating elements of a projection system of a lithographic apparatus, said aberration data being described in terms of a first basis;
determining correctable slit shapes relating to an exposure slit of the lithographic apparatus from the input lens model dependency data;
determining at least one wavefront shape for each said correctable slit shape to determine a candidate matrix;
determining a plurality of correctable components by ranking said candidate matrix in terms of correction potential and/or manipulator range usage, each said correctable component defining a basis function of a second basis, said second basis being different to said first basis; and
determining compact lens model dependency data in terms of said second basis.

2. A method of clause 1, wherein said step of determining correctable slit shapes comprises performing a first multivariate analysis on said input lens model dependency data to identify said correctable slit shapes.

3. A method of clause 2, wherein said input lens model dependency data relates to multiple exposure slit sample points; the method further comprising:
using said correctable slit shapes in place of said exposure slit sample points for modeling lens dependencies described in said input lens model dependency data.

4. A method of clause 2 or 3, wherein said first multivariate analysis comprises a principal component analysis.

5. A method of any preceding clause, wherein the number of correctable slit shapes used in the step of determining at least one wavefront shape for each correctable slit shape is fewer than forty.

6. A method of any preceding clause, wherein the number of correctable slit shapes used in the step of determining at least one wavefront shape for each correctable slit shape is fewer than ten.

7. A method of any preceding clause, wherein said determining at least one wavefront shape for each said correctable slit shape comprises performing a second multivariate analysis to determine at least one dominant component within said aberration data for each combination of correctable slit shape and wavefront shape.

8. A method of clause 7, wherein said second multivariate analysis comprises a principal component analysis and said at least one dominant component comprises at least a first principal component.

9. A method of any preceding clause, wherein said ranking step ranks the candidate matrix in terms of one or more performance indicators.

10. A method of clause 9, wherein said one or more performance indicators comprises one or more of: a get-set error performance indicator, a parasitic performance indicator and/or a manipulator range usage performance indicator.

11. A method of clause 9 or 10, wherein said plurality of correctable components are determined as comprising each said dominant component which meets a respective threshold for at least one of said one or more performance indicators.

12. A method of any preceding clause, wherein said step of determining a plurality of correctable components comprises applying regularization for limiting range usage by defining a minimum required correction range for each correctable component.

13. A method of clause 12, wherein said step of determining a plurality of correctable components is performed iteratively to determine said regularization.

14. A method of any preceding clause, comprising determining a plurality of virtual manipulators, each virtual manipulator being a combination of two or more of said manipulators.

15. A method of clause 14, comprising determining said plurality of virtual manipulators by:

determining get correctable components as those obtained for set correctable components via said lens model; fitting the get correctable components to said input lens dependency data to obtain said compact lens model dependency data; and

performing a third multivariate analysis on the compact lens model dependency data to identify dominant lens calibration dependency components.

16. A method of clause 15, wherein:

said step of fitting the set correctable components is performed without any regularization for limiting range usage applied; and

said step of fitting the get correctable components is performed with regularization for limiting range usage applied.

17. A method of clause 15 or 16, comprising determining one or more neutral virtual manipulators from said virtual manipulators, said neutral virtual manipulators having a non-negligible actuation range over which aberration dependency is low or negligible.

18. A method of clause 17, comprising determining said one or more neutral virtual manipulators by:

fitting each of the virtual manipulators on all of the other virtual manipulators to obtain neutral candidates; performing a fourth multivariate analysis on the neutral candidates; and

fitting the neutral candidates to the get correctable components so as to select those with smallest aberration dependency.

19. A method of any of clauses 15 to 18, wherein said third and/or fourth multivariate analysis each comprises a principal component analysis.

20. A method of any of clauses 15 to 19, comprising calibrating one or more of the highest ranking virtual manipulators as determined by said third multivariate analysis.

21. A method of any preceding clause, comprising using said compact lens model dependency data as a lens model for determining projection system corrections from wavefront measurements in a lithographic process.

22. A computer program comprising program instructions operable to perform the method of any of clauses 1 to 21, when run on a suitable apparatus.

23. A non-transient computer program carrier comprising the computer program of clause 22.

24. A processing arrangement comprising:

a non-transient computer program carrier comprising a computer program of clause 22; and a processor operable to run the computer program comprised on said non-transient computer program carrier.

25. A lithographic apparatus comprising the processing arrangement of clause 24.

26. A lithographic apparatus being operable to perform the method of any of clauses 1 to 21.

The breadth and scope of the present invention should not be limited by any of the above-described exemplary embodiments, but should be defined only in accordance with the following claims and their equivalents.

## Claims

1. A method of determining compact lens model dependency data; the method comprising:

obtaining input lens model dependency data describing relationships between aberration data and a plurality of manipulators for manipulating elements of a projection system of a lithographic apparatus, said aberration data being described in terms of a first basis;

determining correctable slit shapes relating to an exposure slit of the lithographic apparatus from the input lens model dependency data;

determining at least one wavefront shape for each said correctable slit shape to determine a candidate matrix;

determining a plurality of correctable components by ranking said candidate matrix in terms of correction potential and/or manipulator range usage, each said correctable component defining a basis function of a second basis, said second basis being different to said first basis; and

determining compact lens model dependency data in terms of said second basis.

2. A method as claimed in claim 1, wherein said step of determining correctable slit shapes comprises performing a first multivariate analysis on said input lens model dependency data to identify said correctable slit shapes.

3. A method as claimed in claim 2, wherein said input lens model dependency data relates to multiple exposure slit sample points; the method further comprising:

using said correctable slit shapes in place of said exposure slit sample points for modeling lens dependencies described in said input lens model dependency data.

4. A method as claimed in claim 2 or 3, wherein said first multivariate analysis comprises a principal component analysis.

5. A method as claimed in any preceding claim, wherein said determining at least one wavefront shape for each said correctable slit shape comprises performing a second multivariate analysis to determine at least one dominant component within said aberration data for each combination of correctable slit shape and wavefront shape.

6. A method as claimed in claim 5, wherein said second multivariate analysis comprises a principal component analysis and said at least one dominant component comprises at least a first principal component.

7. A method as claimed in any preceding claim, wherein said ranking step ranks the candidate matrix in terms of one or more performance indicators.

8. A method as claimed in claim 7, wherein said one or more performance indicators comprises one or more of: a get-set error performance indicator, a parasitic performance indicator and/or a manipulator range usage performance indicator.

9. A method as claimed in any preceding claim, wherein said step of determining a plurality of correctable components comprises applying regularization for limiting range usage by defining a minimum required correction range for each correctable component.

10. A method as claimed in claim 9, wherein said step of determining a plurality of correctable components is performed iteratively to determine said regularization.

11. A method as claimed in any preceding claim, comprising determining a plurality of virtual manipulators, each virtual manipulator being a combination of two or more of said manipulators.

12. A method as claimed in claim 11, comprising determining said plurality of virtual manipulators by:

determining get correctable components as those obtained for set correctable components via said lens model;
fitting the get correctable components to said input lens dependency data to obtain said compact lens model dependency data; and
performing a third multivariate analysis on the compact lens model dependency data to identify dominant lens calibration dependency components.

13. A method as claimed in claim 12, wherein:

said step of fitting the set correctable components is performed without any regularization for limiting range usage applied; and
said step of fitting the get correctable components is performed with regularization for limiting range usage applied.

**14.** A computer program comprising program instructions operable to perform the method of any of claims 1 to 13, when run on a suitable apparatus.

**15.** A lithographic apparatus being operable to perform the method of any of claims 1 to 13.

Fig. 1

Fig. 2

Fig. 3

Fig. 4

```
        ┌──────────────┐
       /      300      /
      └──────────────┘
              │
              ▼
       ┌──────────────┐
       │      500     │
       └──────────────┘
              │
              ▼
       ┌──────────────┐
       │      510     │
       └──────────────┘
              │
              ▼
       ┌──────────────┐
       │      520     │
       └──────────────┘
              │
              ▼
       ┌──────────────┐
       │      530     │
       └──────────────┘
              │
              ▼
       ┌──────────────┐
       │      540     │
       └──────────────┘
              │
              ▼
        ┌──────────────┐
       /      550      /
      └──────────────┘
```

Fig. 5

**EP 4 564 096 A1**

# EUROPEAN SEARCH REPORT

**Application Number**

EP 23 21 3585

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/367231 A1 (SCHNEIDER EVA [DE] ET AL) 16 November 2023 (2023-11-16) * paragraphs [0022] - [0026], [0044], [0137] - [0142], [0161], [0162] * | 1-15 | INV. G03F7/20 |
| A | WO 2014/139719 A1 (ZEISS CARL SMT GMBH [DE]) 18 September 2014 (2014-09-18) * page 3, lines 12-25 * | 1-15 | |
| A | WO 2016/169890 A1 (ASML NETHERLANDS BV [NL]) 27 October 2016 (2016-10-27) * paragraphs [0091], [0128], [0129], [0232] * | 1-15 | |

**TECHNICAL FIELDS SEARCHED (IPC)**

G03F

The present search report has been drawn up for all claims

| Place of search | Date of completion of the search | Examiner |
|---|---|---|
| Munich | 10 June 2024 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 3585

This annex lists the patent family members relating to the patent documents cited in the above-mentioned European search report.
The members are as contained in the European Patent Office EDP file on
The European Patent Office is in no way liable for these particulars which are merely given for the purpose of information.

10-06-2024

| Patent document cited in search report | Publication date | Patent family member(s) | | Publication date |
|---|---|---|---|---|
| US 2023367231 A1 | 16-11-2023 | CN | 116710847 A | 05-09-2023 |
| | | KR | 20230130117 A | 11-09-2023 |
| | | US | 2023367231 A1 | 16-11-2023 |
| | | WO | 2022156875 A1 | 28-07-2022 |
| WO 2014139719 A1 | 18-09-2014 | CN | 105122142 A | 02-12-2015 |
| | | DE | 102013204391 B3 | 28-05-2014 |
| | | JP | 6339117 B2 | 06-06-2018 |
| | | JP | 2016510142 A | 04-04-2016 |
| | | KR | 20150132293 A | 25-11-2015 |
| | | TW | 201504770 A | 01-02-2015 |
| | | WO | 2014139719 A1 | 18-09-2014 |
| WO 2016169890 A1 | 27-10-2016 | CN | 107710076 A | 16-02-2018 |
| | | JP | 6510675 B2 | 08-05-2019 |
| | | JP | 2018513997 A | 31-05-2018 |
| | | KR | 20170141739 A | 26-12-2017 |
| | | NL | 2016625 A | 24-10-2016 |
| | | TW | 201702569 A | 16-01-2017 |
| | | US | 2018088467 A1 | 29-03-2018 |
| | | WO | 2016169890 A1 | 27-10-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020001088 A